(19) Europäisches Patentamt / European Patent Office / Office européen des brevets

(11) **EP 4 394 512 A1**

(12) **EUROPEAN PATENT APPLICATION**

(43) Date of publication:
**03.07.2024 Bulletin 2024/27**

(21) Application number: **22216705.8**

(22) Date of filing: **27.12.2022**

(51) International Patent Classification (IPC):
**G03F 7/20** (2006.01)

(52) Cooperative Patent Classification (CPC):
**G03F 7/70125; G03F 7/70441; G03F 7/705;
G03F 7/70891**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventor: **STAALS, Frank
5500 AH Veldhoven (NL)**

(74) Representative: **ASML Netherlands B.V.
Corporate Intellectual Property
P.O. Box 324
5500 AH Veldhoven (NL)**

(54) **SOURCE MASK OPTIMIZATION BASED ON SYSTEMATIC EFFECTS ON A LITHOGRAPHIC APPARATUS**

(57) Source mask optimization (SMO) is described. The SMO comprises determining a source configuration (e.g., an illumination pupil) of the lithographic apparatus for first features in a first layer of a pattern based on systematic effects on the lithographic apparatus components that cause feature dependent imaging performance changes for second features in a second layer of the pattern. The systematic effects on the lithographic apparatus components comprise mirror heating, for example. Mirror heating based SMO is performed for a first layer's illumination pupil with a cost function for second layer's performance. For example, mirror heating based SMO may be performed to generate a metal layer illumination pupil that creates less mirror heating impact to a subsequent via layer exposure, and/or mirror heating based SMO may be performed to generate a via layer illumination pupil that is less sensitive to mirror heating caused by a prior metal layer exposure, as representative examples.

FIG. 7

EP 4 394 512 A1

**Description**

TECHNICAL FIELD

The present disclosure relates to source mask optimization based on systematic effects on a lithographic apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k1 lithography may be used to process features with dimensions smaller than the classical resolution limit of a lithographic apparatus. In such a process, the resolution formula may be expressed as $CD = k1_x \, X/NA$, where X is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, source mask optimization (SMO), or other methods generally defined as "resolution enhancement techniques" (RET).

SUMMARY

According to embodiments of the present disclosure, systematic effect (e.g., mirror heating) based source optimization is performed to obtain a first layer's source configuration (e.g., illumination pupil) in a lithographic process based on prediction or evaluation of a second layer's performance. In some embodiments, mirror heating based SMO may be performed to generate a prior (first) (e.g., metal) layer illumination pupil with mitigated mirror heating impact to a subsequent (second) (e.g., via) layer patterning. In some embodiments, mirror heating based SMO may be performed to generate a second (e.g., via) layer illumination pupil with reduced sensitivity to mirror heating induced aberration caused by prior metal layer exposure(s). Note that the layers in this example may be reversed such that the via layer is the first layer and the metal layer is the second layer, the first and second layers may both be metal or both be via layers, the layers may be associated with different wafers in different production lots, and/or other configurations are possible. This contrasts with existing mirror heating aware source mask optimization approaches which typically optimize the source and optionally a mask for a pattern layer based on the same layer's predicted performance, which factors in mirror heating associated only with that layer.

According to an embodiment, there is provided a method for source optimization or source mask optimization for a lithographic apparatus. The lithographic apparatus comprises components configured to image a pattern onto a substrate. The method comprises determining a source configuration of the lithographic apparatus for first features in a first layer of the pattern based on systematic effects on the lithographic apparatus components that cause feature dependent imaging performance changes for second features in a second layer, where the second and the first layers can be of the same pattern or different patterns. The first layer is processed (e.g., exposed) on the lithographic apparatus before the second layer, for example. In some embodiments, the first layer is to be processed immediately before the second layer. In some embodiments, the first layer is to be processed before another layer and then the second layer. A model (e.g., a mirror heating model) may be used to simulate the systematic effects during a lithography process of the first layer. In some embodiments, determining a source configuration comprises determining an illumination pupil and/or other operations.

In some embodiments, the systematic effects on the lithographic apparatus components are caused by one or more prior exposures for one or more prior patterning operations. In some embodiments, the systematic effects on the lithographic apparatus components are determined by simulation based on one or more prior exposures for one or more prior patterning operations. In some embodiments, the systematic effects on the lithographic apparatus components are an input to the source mask optimization. In some embodiments, the systematic effects on the lithographic apparatus components comprise component heating, component cooling, component drift, component variation for different substrate lots, illumination offsets, mask to mask changes, overlay effects, aberration effects, fading, re-calibration or re-setup, and/or dose or pupil residuals.

In some embodiments, the lithographic apparatus components comprise a mirror, a lens, and/or a full optical system (e.g., that includes one or more mirrors, one or more lenses, and/or or several other components), and the systematic effects on the lithographic apparatus comprise mirror and/or lens heating.

In some embodiments, the systematic effects on the lithographic apparatus components vary over time during exposure and/or over multiple exposures.

In some embodiments, feature dependent imaging performance changes comprise changes that vary based on a shape, location, dimensions, material, layer, and/or function of a feature in a layer of the pattern.

In some embodiments, the method comprises determining the source configuration based on systematic effects on the lithographic apparatus components that cause feature dependent imaging performance changes for the first features in the first layer and the second features in the second layer of the pattern. Determining the source configuration for the first features comprises co-optimization of the source configuration for the first features in the first layer and the second features in the second layer of the pattern based on the systematic effects as simulated or measured on the lithographic apparatus components that cause feature dependent imaging performance changes for the first and second features.

In some embodiments, the method comprises determining a second source configuration for the second features in the second layer of the pattern based on a second feature sensitivity to the systematic effects , wherein the systematic effect is associated with processing the first features of the first layer. The first layer is to be processed before the second layer. In some embodiments, the sensitivity corresponds to sensitivity of imaging performance to heating effect. In some embodiments, the sensitivity corresponds to aberration (Zernike or Tatian) sensitivity of important cutline metrics, including EPE, CD, and PPE sensitivities. The sensitivity indicates how severe the metric is impacted by the aberration wavefront. The source configuration for processing the second layer is determined based on systematic effects on the lithographic apparatus components that is caused by processing the first features in the first layer. In some embodiments, the sensitivity is determined by simulation based on one or more prior exposures for one or more prior patterning operations. In some embodiment, a mirror heating model is used to predict the heating effect resulting from processing the first layer, and the model output (e.g., resultant wavefront or aberration) is used in a source optimization process to generate a source configuration for processing the second layer. In some embodiment, the source optimization process uses a cost function including indication of second layer's sensitivity to mirror heating induced aberration.

In some embodiments, the first features can be produced using a first mask comprising a first portion of a pattern design layout, and the second features are produced with a second mask comprising a second portion of the same pattern design layout, or a different pattern design layout.

In some embodiments, determining the source configuration comprises performing source mask optimization on the source configuration for the first features in the first layer with a cost function indicating imaging performance of the second features in the second layer.

The two layers may belong to the same pattern or different patterns, the same design layout or different design layout, and/or the same or different products (e.g., wafers). In some embodiments, the first layer is a metal layer and the second layer is a via layer. In some embodiments, the first (e.g., metal) layer is exposed before the second (e.g., via) layer, and heating from exposing the first layer is accounted for when determining the source configuration of the lithographic apparatus for features (e.g., vias) in the second layer. Note that the layers in this example may be reversed such that the via layer is the first layer and the metal layer is the second layer, the first and second layers may both be metal or both be via layers, the layers may be associated with different wafers in different production lots, and/or other configurations are possible. In some embodiments, the source configuration or the first layer is optimized such that the systematic effect generated during processing of the first layer has reduced or eliminated impact on imaging performance of the subsequently processed second layer(s). In some embodiments, the source configuration for a subsequently processed second layer is determined such that the imaging performance has reduced sensitivity to systematic effects caused by previously processing the first layer.

In some embodiments, the source configuration is determined based on a lithography simulation of imaging the first features, and an edge placement error cost function generated for the first features comprising one or more terms for the systematic effects on the lithographic apparatus components that cause the imaging performance changes for the second features in the second layer. Simulating based on first features may comprise using the mask patterns designed for the first layer in the source optimization or source mask optimization process, for example. During a lithography simulation, the systematic effect may be modeled based on the first layer features with a mirror heating model, for example. During the source optimization (for processing the first layer), the source is adjusted based on a cost function that contains indications of predicted imaging performance of the second layer (e.g., one or more second layers as described herein). The cost function may also contain indications of predicted imaging performance of the first layer.

In some embodiments, the lithographic apparatus components comprise an illumination source and projection optics configured to image the pattern onto the substrate. The method comprises determining one or more adjustments for one or more of the source configuration, the pattern, the projection optics, or the illumination source based on the systematic effects on the lithographic apparatus components that cause the feature dependent imaging performance changes until a termination condition is satisfied. In some embodiments, the termination condition comprises a determination that features patterned onto the substrate will substantially match a target design.

In some embodiments, performing the source mask optimization comprises modeling a lithographic process for imaging the pattern onto the substrate. In some embodiments, a model for modeling the process for imaging the pattern onto the substrate uses a determined source configuration.

In some embodiments, the method comprises mask co-optimization with the source configuration for the first features in the first layer of the pattern based on the systematic effects on the lithographic apparatus components that cause the imaging performance changes for the second features in the second layer of the pattern.

In some embodiments, there is provided a non-transitory computer readable medium having instructions thereon, the instructions when executed by a computer causing the computer to perform one or more of the operations of the method described above.

In some embodiments, there is provided a system comprising one or more processors configured by machine readable instructions to perform one or more of the operations of the method described above.

Other advantages of the embodiments of the present disclosure will become apparent from the following description taken in conjunction with the accompanying drawings, which set forth, by way of illustration and example, certain example embodiments.

## BRIEF DESCRIPTION OF THE DRAWINGS

The accompanying drawings, which are incorporated in and constitute a part of the specification, illustrate one or more embodiments and, together with the description, explain these embodiments. Embodiments will now be described, by way of example only, with reference to the accompanying schematic drawings in which corresponding reference symbols indicate corresponding parts, and in which:

Figure 1 is a schematic diagram of a lithographic projection apparatus, according to an embodiment.

Figure 2 depicts a schematic overview of a lithographic cell, according to an embodiment.

Figure 3 depicts a schematic representation of holistic lithography, representing a cooperation between three technologies to optimize semiconductor manufacturing, according to an embodiment.

Figure 4 schematically illustrates basic principles of source mask optimization, according to an embodiment.

Figure 5 plots wavefront aberration over time (in a given production lot) caused by mirror heating, according to an embodiment.

Figure 6 illustrates an exemplary method for systemic effect aware source mask optimization for a lithographic apparatus, according to an embodiment.

Figure 7 provides an illustration of determining a source configuration of a lithographic apparatus for first features in a first layer of a pattern based on systematic effects on the lithographic apparatus components that cause feature dependent imaging performance changes for second features in a second layer of the pattern, according to an embodiment.

Figure 8 illustrates an existing systematic effect (e.g., mirror heating) based source mask optimization compared to new systematic effect (e.g., mirror heating) based source mask optimization methods described herein, according to an embodiment.

Figure 9 illustrates that determining a source configuration of the lithographic apparatus for first features in a first layer of the pattern based on systematic effects on the lithographic apparatus components that cause feature dependent imaging performance changes for second features in a second layer of the pattern is not limited to input from just one (second) layer, according to an embodiment.

Figure 10 is a diagram of an example computer system that may be used for one or more of the operations described herein, according to an embodiment.

## DETAILED DESCRIPTION

Source optimization (SO) or SMO for a lithographic apparatus to reduce systematic impact in lithography process is described. The SO comprises determining a source configuration (e.g., determining an illumination pupil) of the lithographic apparatus for first features in a first layer of a pattern based on systematic effect impact on imaging performance of second features in a second layer that is processed later than the first layer. Although embodiments of the present disclosure are described in greater detail with respect to the mirror heating effect, the present disclosure can be used to address other systematic effects, such as component heating, component cooling, component drift, component variation for different substrate lots, illumination offsets, mask to mask changes, overlay effects, aberration effects, fading, re-calibration or re-setup, and/or dose or pupil residuals, etc.. Layers of a pattern may refer to different layers of the same pattern for one product, a first layer for one product and a second layer for a different product, etc. (e.g., not necessarily simply an order of layers in a single stack).

Mirror heating (as one possible representative example of a systematic effect) aware SMO typically optimizes the source, and in some cases a mask, for a pattern layer based on that layer's imaging performance considering mirror heating associated only with processing that layer, where the mirror heating effect can be determined by simulation or by using empirical data . The result is often a source configuration (e.g., an illumination pupil) with a slightly less nominal (imaging) contrast performance, but with better contrast performance under mirror heating conditions for that layer. This reduces the impact on imaging caused by the heat for that layer, and/or reduces the aberration sensitivity of the layer, for example. However, sometimes issues caused by mirror heating are not (or not only or not primarily) caused by mirror heating associated with a current layer, but mirror heating from prior exposures affecting another (or next patterned) layer. For example, mirror heating associated with a first exposure for a first (e.g., metal) layer can affect a second patterned (e.g., via) layer exposure.

In contrast to prior approaches, the present systems and methods are configured such that systematic effect (e.g., mirror heating) based SMO is performed for a first layer's source configuration (e.g., illumination pupil) with a cost function for second (a different) layer's performance. As described below, the order of lot exposures on a lithographic apparatus is relevant to wafer imaging performance. A layer B may suffer from mirror heating caused by patterning operations associated with layer A, where A is exposed before B; but layer B may be either higher or lower in a stack, or be part of a completely different product. As a specific example, mirror heating based SMO may be performed to generate a metal layer illumination pupil that creates less mirror heating impact to a subsequent via layer exposure, and/or mirror heating based SMO may be performed to generate a via layer illumination pupil that is less sensitive to mirror heating caused by prior metal layer exposure.

Embodiments of the present disclosure are described in detail with reference to the drawings, which are provided as illustrative examples of the disclosure so as to enable those skilled in the art to practice the disclosure. The figures and examples below are not meant to limit the scope of the present disclosure to a single embodiment, but other embodiments are possible by way of interchange of some or all of the described or illustrated elements. Where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. The present disclosure encompasses present and future known equivalents to the known components referred to herein by way of illustration.

Although specific reference may be made in this text to the manufacture of integrated circuits (ICs), it should be understood that the description herein has many other applications. For example, it may be employed in the manufacture of integrated optical systems, guidance and detection patterns for magnetic domain memories, liquid crystal display (LCD) panels, thin film magnetic heads, etc. The skilled artisan will appreciate that, in the context of such alternative applications, any use of the terms "reticle," "wafer" or "die" in this text should be considered as interchangeable with the more general terms "mask," "substrate," and "target," respectively.

In the present document, the terms "radiation" and "beam" are used to encompass all types of electromagnetic radiation, including ultraviolet radiation (e.g., with a wavelength of 365, 248, 193, 157 or 126 nm) and EUV (extreme ultra-violet radiation, e.g., having a wavelength in the range of about 5-100 nm).

A (e.g., semiconductor) patterning device can comprise, or can form, one or more design layouts. The design layout can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between devices (such as gates, capacitors, etc.) or interconnect lines, so as to ensure that the devices or lines do not interact with one another in an undesirable way. The design rules may include or specify specific parameters, limits on ranges for parameters, or other information. One or more of the design rule limitations or parameters may be referred to as a "critical dimension" (CD). A critical dimension of a device can be defined as the smallest width of a line or hole or the smallest space between two lines or two holes, or other features. Thus, the CD determines the overall size and density of the designed device. One of the goals in device fabrication is to faithfully reproduce the original design intent on the substrate (via the patterning device).

The term "mask" or "patterning device" as employed in this text may be broadly interpreted as referring to a generic semiconductor patterning device that can be used to endow an incoming radiation beam with a patterned cross-section, corresponding to a pattern that is to be created in a target portion of the substrate. Besides the classic mask (transmissive or reflective; binary, phase-shifting, hybrid, etc.), examples of other such patterning devices include a programmable mirror array and a programmable LCD array.

As used herein, the term "patterning process" means a process that creates an etched substrate by the application of specified patterns of light as part of a lithography process. However, "patterning process" can also include (e.g., plasma) etching, as many of the features described herein can provide benefits to forming printed patterns using etch (e.g., plasma) processing.

As used herein, the term "pattern" means an idealized pattern that is to be etched on a substrate (e.g., wafer). A pattern may have two or three dimensions, be formed in layers, and/or have other characteristics.

As used herein, a "printed pattern" (or a pattern on a substrate) means the physical pattern on a substrate that was etched based on a target pattern. The printed pattern can include, for example, troughs, channels, depressions, edges, or other two and three dimensional features resulting from a lithography process.

As used herein, the term "calibrating" means to modify (e.g., improve or tune) or validate something, such as a model.

A patterning system may be a system comprising any or all of the components described herein, plus other components configured to performing any or all of the operations associated with these components. A patterning system may include a lithographic projection apparatus, a scanner, systems configured to apply or remove resist, etching systems, or other systems, for example.

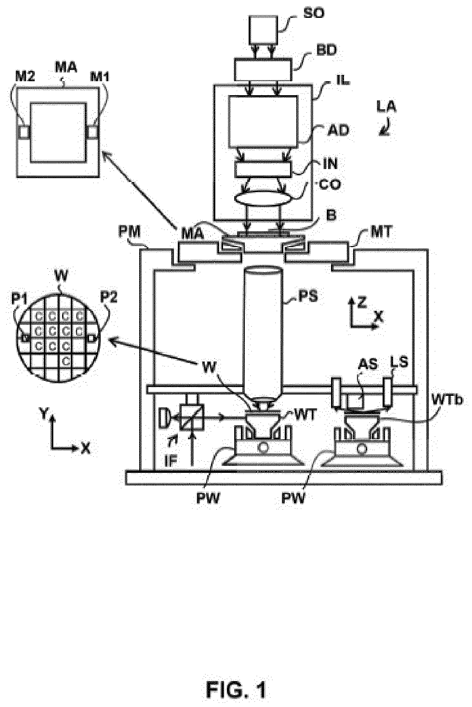

As an introduction, Figure 1 is a schematic diagram of a lithographic projection apparatus LA, according to an embodiment. The lithographic projection apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, for example, so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

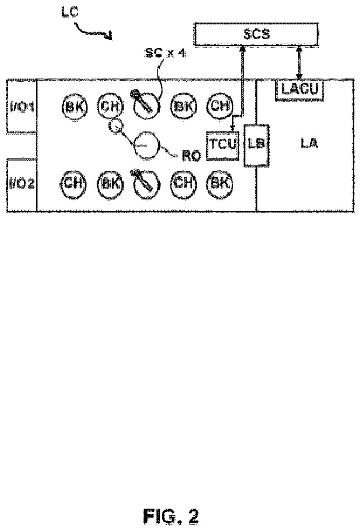

Figure 2 depicts a schematic overview of a lithographic cell LC. As shown in Figure 2, a lithographic projection apparatus (shown in Figure 1 and illustrated as lithographic apparatus LA in Figure 2) may form part of lithographic cell LC, also sometimes referred to as a lithocell or (litho)cluster, which often also includes apparatus to perform pre- and post-exposure processes on a substrate W (Figure 1). Conventionally, these include spin coaters SC configured to deposit resist layers, developers to develop exposed resist, chill plates CH and bake plates BK, e.g., for conditioning the temperature of substrates W, e.g., for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g., via lithography control unit LACU.

In order for the substrates W (Figure 1) exposed by the lithographic apparatus LA to be exposed correctly and consistently, it is desirable to inspect substrates to measure properties of patterned structures, such as feature edge placement, overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties using an actual substrate (e.g., a charged particle - SEM - image of a wafer pattern) or an image of an actual substrate, on a latent image (image in a resist layer after the exposure), on a semi-latent image (image in a resist layer after a post-exposure bake step PEB), on a developed resist image (in which the exposed or unexposed parts of the resist have been removed), on an etched image (after a pattern transfer step such as etching), or in other ways.

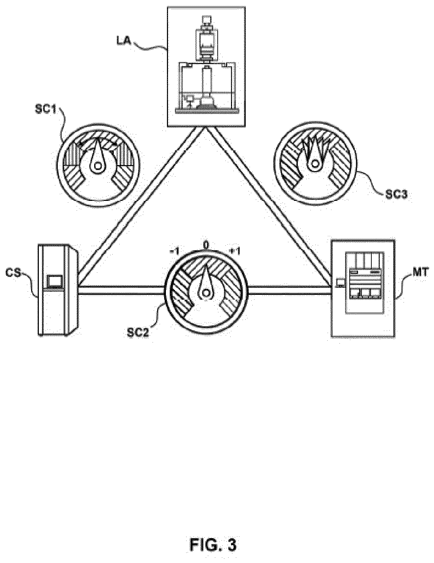

Figure 3 depicts a schematic representation of holistic lithography, representing a cooperation between three technologies to optimize semiconductor manufacturing. Typically, the patterning process in lithographic apparatus LA is one of the most critical steps in the processing which requires high accuracy of dimensioning and placement of structures on the substrate W (Figure 1). To ensure this high accuracy, three systems (in this example) may be combined in a so called "holistic" control environment as schematically depicted in Figure. 3. One of these systems is lithographic apparatus LA which is (virtually) connected to a metrology apparatus (e.g., a metrology tool) MT (a second system), and to a computer system CS (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g., dose, focus, overlay) within which a specific manufacturing process yields a defined result (e.g., a functional semiconductor device) - typically within which the process parameters in the lithographic process or patterning process are allowed to vary.

The computer system CS may use (part of) a design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CS may also be used to detect where within the process window the lithographic apparatus LA is currently operating (e.g., using input from the metrology tool MT) to predict whether defects may be present due to e.g., sub-optimal processing (depicted in Figure 3 by the arrow pointing "0" in the second scale SC2).

The metrology apparatus (tool) MT may provide input to the computer system CS to enable accurate simulations and predictions, and may provide feedback to the lithographic apparatus LA to identify possible drifts, e.g., in a calibration status of the lithographic apparatus LA (depicted in Figure 3 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes (SEM) or various forms of scatterometer metrology tools MT.

In some embodiments, metrology tools MT are or include a spectroscopic scatterometer, an ellipsometric scatterometer, or other light based tools. A spectroscopic scatterometer may be configured such that the radiation emitted by a radiation source is directed onto target features of a substrate and the reflected or scattered radiation from the target is directed to a spectrometer detector, which measures a spectrum (i.e., a measurement of intensity as a function of wavelength) of the specular reflected radiation. From this data, the structure or profile of the target giving rise to the detected spectrum may be reconstructed, e.g., by rigorous coupled wave analysis and non-linear regression or by comparison with a library of simulated spectra. An ellipsometric scatterometer allows for determining parameters of a lithographic process by measuring scattered radiation for each polarization states. Such a metrology tool (MT) emits polarized light (such as linear, circular, or elliptic) by using, for example, appropriate polarization filters in the illumination section of the metrology apparatus. A source suitable for the metrology apparatus may provide polarized radiation as well.

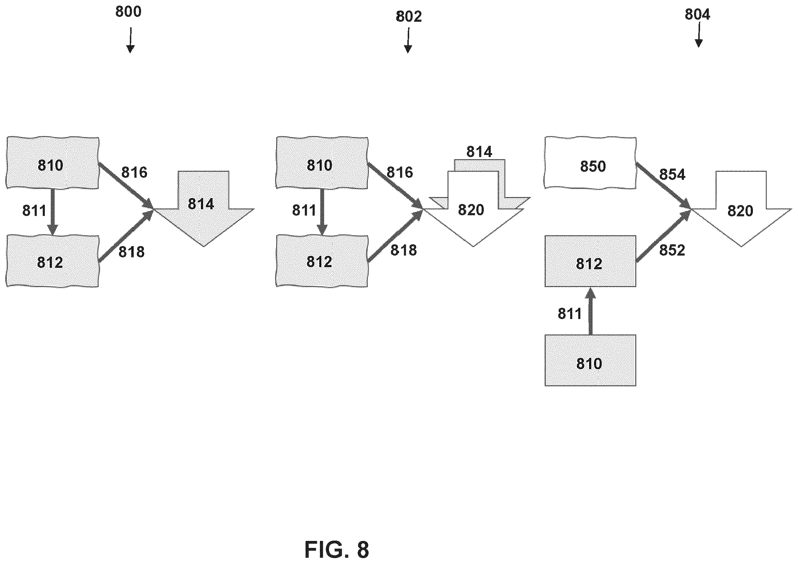

It is often desirable to be able to computationally determine how a patterning process would produce a desired pattern on a substrate. Thus, simulations may be provided to simulate one or more parts of the process. The computational determinations and/or simulations may be performed on a computing device such as computing device CS shown in Figure 3 (and again in Figure 8 below).

For example, the computational determinations and/or simulations can be used to configure one or more features of the patterning device pattern (e.g., performing optical proximity correction), one or more features of the illumination (e.g., changing one or more characteristics of a spatial / angular intensity distribution of the illumination, such as changing an illumination pupil shape), and/or one or more features of the projection optics (e.g., numerical aperture, etc.). This configuration can be generally referred to as, respectively, mask optimization, source optimization, and projection optimization. Optimizations can be performed on their own, or combined in different combinations. One example is source-mask optimization (SMO), which involves the configuring of one or more features of the patterning device pattern together with one or more features of the illumination. For example, a prior art source mask optimization process is described in United States Patent No. 9,588,438 titled "Optimization Flows of Source, Mask and Projection Optics", which is incorporated in its entirety by reference.

In some embodiments, an optimization process of a system, such as SMO, may be represented as a cost function. The optimization process may comprise finding a set of parameters (source configurations, design variables, process variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system, a design, or the fabrication method. The design and/or process variables of the system can be confined to finite ranges and/or be interdependent due to practicalities of implementations of the system, design, and/or method. In the case of SMO and a lithographic projection apparatus, the constraints are often associated with physical properties and characteristics of the hardware such as tunable ranges, and/or patterning device manufacturability design rules. The evaluation points can include physical points on a resist image on a substrate (e.g., associated with edge placement error and/or other key performance indicators), as well as non-physical characteristics such as dose and focus, for example.

In a lithographic projection apparatus, as an example, a cost function CF may be expressed as

$$CF(z_1, z_2, \cdots, z_N) = \sum_{p=1}^{P} w_p f_p^2(z_1, z_2, \cdots, z_N)$$

where $(z_1, z_2, \cdots, z_N)$ are N design variables or values thereof, and $f_p(z_1, z_2, \cdots, z_N)$ can be a function of the design variables $(z_1, z_2, \cdots, z_N)$ such as a difference between an actual value and an intended value of a characteristic for a set of values of the design variables of $(z_1, z_2, \cdots, z_N)$. In some embodiments, $w_p$ is a weight constant associated with $f_p(z_1, z_2, \cdots, z_N)$. For example, the characteristic may be a position of an edge of a pattern, measured at a given point on the edge. Different $f_p(z_1, z_2, \cdots, z_N)$ may have different weight $w_p$. For example, if a particular edge has a narrow range of permitted positions, the weight $w_p$ for the $f_p(z_1, z_2, \cdots, z_N)$ representing the difference between the actual position and the intended position of the edge may be given a higher value. $f_p(z_1, z_2, \cdots, z_N)$ can also be a function of an interlayer characteristic, which is in turn a function of the design variables $(z_1, z_2, \cdots, z_N)$. Of course, $CF(z_1, z_2, \cdots, z_N)$ is not limited to the form in the equation above and $CF(z_1,z_2,\cdots,z_N)$ can be in any other suitable form.

The cost function may represent any one or more suitable characteristics of the lithographic projection apparatus, lithographic process, or the substrate, for instance, a source configuration, a focus, edge placement error (EPE), CD, image shift, image distortion, image rotation, stochastic variation, throughput, local CD variation, process window, an interlayer characteristic, or a combination thereof. In some embodiments, the cost function may include a function that represents one or more characteristics of the resist image. For example, $f_p(z_1,z_2,\cdots,z_N)$ can be a distance between a point in the resist image to an intended position of that point (i.e., edge placement error $EPE_p(z_1, z_2,\cdots,z_N)$. The parameters can include any adjustable parameter such as an adjustable parameter of the source, the patterning device, the projection optics, dose, focus, etc. The parameters may also have constraints, which can be expressed as $(z_1, z_2,\cdots,z_N) \in Z$, where $Z$ is a set of possible values of the parameters. One possible constraint may be a limitation on a source configuration and/or a patterning device pattern for SMO, for example.

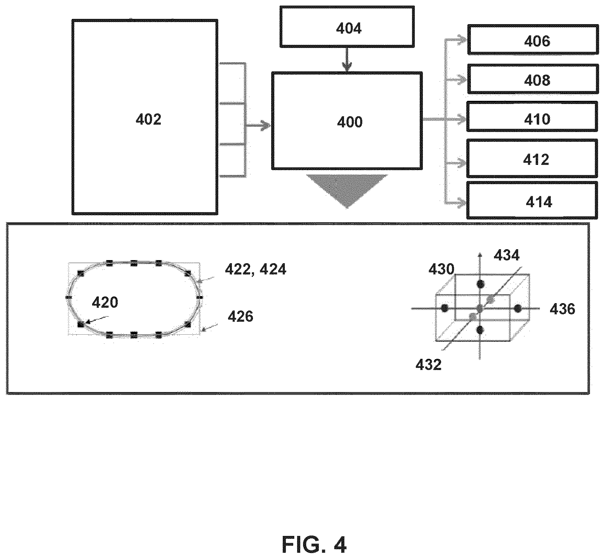

Figure 4 schematically illustrates an exemplary process of SMO 400. SMO 400 may receive one or more inputs 402, such as process information (e.g., in the form of one or more electronic models), a target design, initial processing conditions, flow information (e.g., an SMO.xml file), and or other inputs 402. Process window (PW) conditions 404 are also known. SMO 400 may provide several outputs, including an optimal source configuration 406, an optimal wavefront 408, an optimized mask 410, optimized design rules and/or targets 412, process window and process variation band analysis 414, and/or other outputs.

In some embodiments, SMO 400 may be performed based on a cost function CF such as:

$$CF\left(V_{gc}, V_{mask}, V_{wavefront}, V_{design}\right) = \sum_{pw,eval} (pw, eval) \left|EPE_{pw, eval}\right|^2 + Penalty$$

(e.g., a more specific version of the cost function described above) where $V_{gc}$ are input variables related to process window conditions that may be varied (e.g., focus, dose, reticle writing error, mirror heating Zernikes, Tatian, etc.), $V_{mask}$ are input variables related to a mask, $V_{wavefront}$ are input variables related to a wavefront, and $V_{design}$ are input variables related to a target design. In this example, the SMO cost function is optimized based on edge placement error EPE. Cost function CF also includes a penalty term. The penalty term can be used for boundary conditions, such as for example a normalized image log slope (NILS), a penalty on too high a dose required (throughput), a penalty on an extent of a deviation from an initial pupil or initial target, a penalty associated with RMS of Zernikes, etc. Figure 4 illustrates EPE optimization at evaluation points 420 across multiple process window conditions 422 (showing the shape of a given feature 424 relative to a target design 426 for the feature). Figure 4 also illustrates an example process window box 430 for three different example variables 432, 434, 436. It should be noted that while the cost function CF described above utilizes EPE, additional weight may be added for CD or PPE, for example, a custom cost function based on CD asymmetry may be applied, and/or other cost functions may be used. In general, optimization may be based on any imaging key performance indicator (KPI) that depends on the source and/or pupil being optimized during SMO.

Being able to control or correct for systematic effects on lithographic apparatus components that cause imaging performance changes using SMO is advantageous. For example, systematic effect aware SMO can be used to correct for wavefront drift induced by optical heating such as mirror heating in semiconductor manufacturing processes. By correcting for wavefront drift in a lithography system, where the wavefront drift is induced by the heating of optical elements of the lithography system (e.g., mirrors, lenses, etc.), defects in devices fabricated via one or more of the semiconductor manufacturing processes may be significantly reduced.

In lithography systems, mirror heating, lens heating, and/or other systematically changing factors to the production of patterned devices, such as semiconductor devices, can cause defects (e.g., edge placement errors, overlay errors, etc.). This demands fast and precise in-situ correction capabilities to achieve stable imaging performance in production manufacturing environments. Mirror heating can cause wavefront drift, which is when a wavefront provided by an optical projection system of the lithography system differs from a target wavefront, or a calibrated or cold lithography apparatus state, to be provided by the optical projection system.

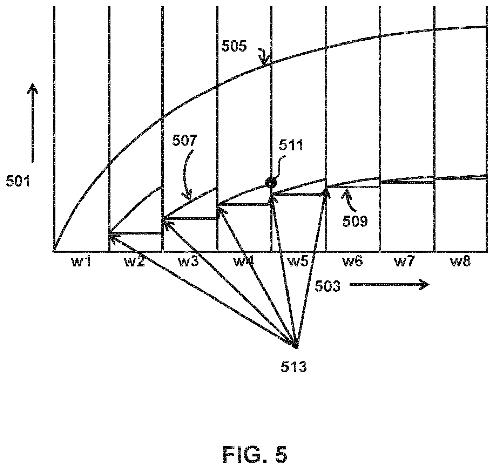

By way of a non-limiting example, Figure 5 plots wavefront aberration (e.g., which can be represented by Zernike or Tatian) 501 over time 503 (in a given production lot) caused by mirror heating. Wafers 1 - 8 (w1, w2, ..., w8) for a wafer production lot are shown in Figure 5. Figure 5 plots a raw 505 aberration drift (e.g., change in Zernike 501 over time 503 caused by mirror heating) that would occur without correction. In contrast, Figure 5 also shows, for each wafer, a mirror heating residual 507, a projection optics correction model residual 509, a last field 511 (which is equal to a worst mirror heating residual) for mirror heating residual 507, and a correction 513 determined by or based on a scanner lens model correction. Mirror heating SMO does not necessarily impact aberration control, but it may impact the raw Zernikes caused, or the sensitivity to the residuals 507. The correction may be applied by a projection optics correction model, for example, and/or other simulation models.

During wafer production, more than 90% of the energy entering the lithography apparatus is absorbed by the optical system and fails to reach the wafer. Due to the intrinsic physical properties of the lithography apparatus mirrors (and/or lenses), the absorbed power heats up the mirrors (and/or lenses), resulting in non-uniform temperature distribution on the mirrors, and causing mirror deformations. In turn, mirror deformation leads to the (e.g., wavefront and/or other) aberrations described above. The aberrations depend on time, power and dose, illumination mode, mask transmission and diffraction, lithography apparatus specifics, applications, and/or other factors. Systematic effect (e.g., mirror heating) aware SMO mitigates these unfavorable conditions. To minimize the negative impact of mirror heating and/or other systematic effects on lithography performance, systematic effect aware SMO provides a method to optimize the source in a dedicated manner so that it is less sensitive to mirror heating and/or other systematic effects, and provides a systematic tool to evaluate mirror heating and/or other systematic effect impacts.

As described above, several variables in the cost function are varied during the optimization process in SMO. With systematic effect or mirror heating aware SMO, Zernikes or Tatians can be also varied using a mirror heating profile as it changes over time. Simulated mirror heating data is typically used as a mirror heating aware SMO input (though measured mirror heating data, a simulated model based on calibrated mirror heating data, and/or other information may be used). SMO typically includes iteratively shifting pixels in a pupil to find a pupil with maximum contrast. Aberrations, illumination errors, and stage errors are assumed to be zero. With systematic effect or mirror heating aware SMO, something less than maximum (imaging) contrast is tolerated, but mirror heating and/or other systematic effects (that cause the aberrations, illumination errors, and stage errors) are accounted for, which enhances the overall accuracy and/or contrast of a patterning process.

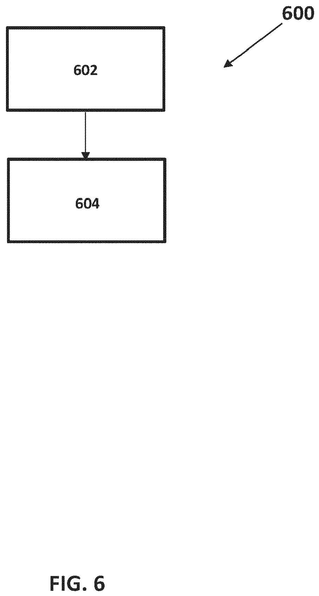

Figure 6 illustrates an exemplary computer implemented method 600 for systemic effect aware SMO for a lithographic apparatus. The SMO of method 600 comprises determining (operation 602) a source configuration (e.g., determining an illumination pupil) of the lithographic apparatus for first features in a first layer of a pattern based on systematic effect impact on feature dependent imaging performance of second features in a second layer. (The systematic effects on the lithographic apparatus components comprise mirror heating and/or other systematic effects, for example.) In some embodiments, method 600 is configured such that systematic effect (e.g., mirror heating) based SMO is performed for a first layer's source configuration (e.g., illumination pupil) with a cost function for second layer's imaging performance, e.g., EPE or other imaging characteristics of the second features. The cost function may represent any one or more suitable characteristics of the lithographic projection apparatus, lithographic process, or the substrate, for instance, a source configuration, a focus, edge placement error (EPE), CD, image shift, image distortion, image rotation, stochastic variation, throughput, local CD variation, process window, an interlayer characteristic, or a combination thereof. Layers of a pattern may refer to different layers of the same pattern for one product, a first layer for one product and a second layer for a different product, etc. (e.g., not necessarily simply an order of layers in a single stack). Method 600 comprises mask co-optimization with the source configuration for the first features in the first layer of the pattern based on the systematic effects on the lithographic apparatus components that cause the feature dependent imaging performance changes for the second features in the second layer of the pattern. Method 600 also includes determining (operation 604) one or more adjustments for one or more of the source configuration, the pattern, the projection optics, the illumination source, and/or other variables based on the systematic effect aware SMO, and/or other operations.

The operations of method 600 are intended to be illustrative. In some embodiments, method 600 may be accomplished with one or more additional operations not described, and/or without one or more of the operations discussed. Additionally, the order in which the operations of method 600 are illustrated in Figure 6 and described herein is not intended to be limiting.

In some embodiments, one or more portions of method 600 may be implemented in and/or controlled by one or more processing devices (e.g., a digital processor, an analog processor, a digital circuit designed to process information, an analog circuit designed to process information, a state machine, and/or other mechanisms for electronically processing information). The one or more processing devices may include one or more devices executing some or all of the operations of method 600 in response to instructions stored electronically on an electronic storage medium. The one or more processing devices may include one or more devices configured through hardware, firmware, and/or software to be specifically designed for execution of one or more of the operations of method 600 (e.g., see discussion related to Figure 8 below).

At operation 602, a source configuration of the lithographic apparatus is determined. Determining the source configuration may include determining characteristics (e.g., shape, size, location, etc.) of an illumination pupil, for example. The source configuration is determined for first features in a first layer of the pattern (e.g., a first layer illumination pupil used in a simulation). The source configuration is determined based on systematic effects on the lithographic apparatus components on the predicted imaging performance of second features in a second layer. The systematic effects on the lithographic apparatus components are caused by one or more prior patterning operations performed with respect to processing the first layer (e.g., exposures and/or other operations) and/or may have other causes. The systematic effects on the lithographic apparatus components can be determined by simulation based the on the one or more prior patterning operations, e.g., by apply a mirror heating model associated with processing the first layer. In some embodiments, the systematic effects can be measured in-situ on scanner or generated based on empirical data. The systematic effects on the lithographic apparatus components can be inputs to the SMO (e.g., as described above). The systematic effects on the lithographic apparatus components may comprise one or more of lithography apparatus component (e.g., mirror and/or or lens) heating, component cooling, component drift, component variation for different substrate lots, illumination offsets, mask to mask changes, overlay effects, aberration effects, fading, dose or pupil residuals, and/or other systematic effects. A model may be configured to simulate these effects as generated in processing.

In some embodiments, the first features are produced using a first mask comprising a first portion of a pattern design layout, and the second features are produced with a second mask comprising a second portion of the pattern design layout.

Determining the source configuration comprises performing source mask optimization on the source configuration for the first features in the first layer with a cost function indicating imaging performance of the second features in the second layer. Performing the source mask optimization may comprise modeling a lithographic process for imaging the pattern onto the substrate. For example, the source configuration may be determined based on a lithography simulation of processing the first features, and source configuration can be optimized by using a cost function (e.g., as one example - the cost function may be based on different and/or additional critical features) containing terms of feature dependent imaging performance for the second features in the second layer of the pattern.

In some embodiments, operation 602 comprises determining the source configuration based on imaging performance changes for both the first features in the first layer and the second features in the second layer of the pattern. For example, the cost function contains terms indicating imaging performance of the first features and the second features. Thus, the source configuration for the first features is determined by way of co-optimization of the source configuration for the first features in the first layer and the second features in the second layer of the pattern

In some embodiments, the lithographic apparatus components comprise a mirror and/or a lens, and the systematic effects on the lithographic apparatus comprise mirror and/or lens heating (e.g., as described above). The systematic effects on the lithographic apparatus components such as mirror and/or lens heating vary over time during exposure. The feature dependent imaging performance may be affected by the systematic effect and the impact is dependent on a shape, location, dimensions, material, layer, and/or function of a feature in a layer of the pattern. For example, mirror and/or lens heating that varies over time during exposure can cause changes in features in a layer of a pattern that vary based on feature shape, location, dimensions, material, layer, and/or function of the feature.

In some embodiments, alternatively or additionally, operation 602 comprises determining a second source configuration for the second features in the second layer of the pattern, the second layer to be processed later than the first layer. The second source configuration may be determined based on a second feature's sensitivity to the systematic effect that is associated with processing the first the layer. In some embodiments, a mirror heating model is applied to predict the heating effect from processing the first layer. The model output can be incorporated in the source optimization process for the second layer, where the source optimization may use a cost function indicating aberration sensitivity (as induced by the heating effect) of the second features. In some embodiments, the cost function in the source optimization process contains EPE and (normalized) image log slopes (ILS or NILS) of the second features. A simulation may be determined based on one or more prior patterning operations (e.g., exposures) for one or more other layers of the pattern (or a different pattern on a different product), and/or other information. In these embodiments, the source configuration for the first layer may be determined in any manner. For example, the source configuration for the first layer may be based on systematic effects on the lithographic apparatus components that cause feature dependent imaging performance changes only for the first features in the first layer, for example.

By way of a non-limiting example, the first layer may be a metal layer and the second layer may be a via layer of the pattern. In this example, the metal layer may be exposed before the via layer, and heating from exposing the metal layer is accounted for when determining the source configuration of the lithographic apparatus for vias in the via layer. The source configuration (e.g., an illumination pupil shape, size, location, etc.) is determined for the metal layer such that feature dependent imaging performance changes to vias in the via layer caused by the systematic effects on the lithographic apparatus components (e.g., mirror and/or lens heating) are reduced or eliminated compared to changes if the source configuration was determined based on features of the metal layer or the via layer alone. In some embodiments, the source configuration is determined for the via layer such that the source configuration is less sensitive to the systematic effects on the lithographic apparatus components that cause feature dependent imaging performance changes to features in the metal layer compared to a sensitivity if the source configuration was determined based on features of the metal layer or the via layer alone.

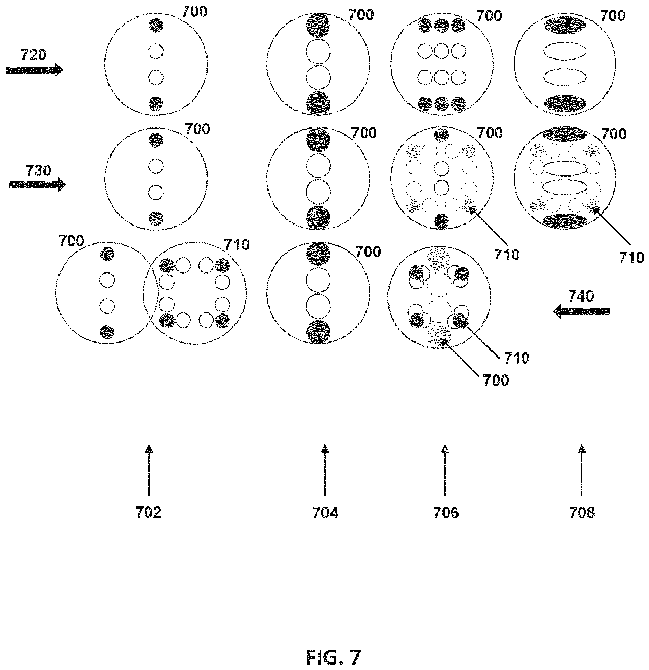

Figure 7 provides a practical illustration of determining a source configuration of a lithographic apparatus for first features in a first layer of a pattern based on systematic effects on the lithographic apparatus components that cause feature dependent imaging performance changes for second features in a second layer of the pattern. In this example, the source configuration is an illumination pupil shape, size, and location. The first features are metal features in a first, metal, layer. The systematic effects on the lithographic apparatus components comprise and/or are caused by mirror heating. The second features are vias in this example in a second, via, layer of the pattern. As described above, layers of a pattern may refer to different layers of the same pattern for one product, a first layer for one product and a second layer for a different product, etc. (e.g., not necessarily simply an order of layers in a single stack).

Figure 7 illustrates metal layer illumination pupils 700 pre-SMO 702, adjusted to minimize metal layer mirror heating 704, adjusted to minimize metal layer sensitivity to mirror heating 706, and a compromise illumination pupil 708. Figure 7 also illustrates via layer pupils 710. Note that the layers in this example may be reversed such that the via layer is the first layer and the metal layer is the second layer, the first and second layers may both be metal or both be via layers, and/or other configurations are possible. The top row 720 of Figure 7 shows a metal layer illumination pupil 700 optimized for (1) metal layer heating and for (2) metal layer sensitivity to mirror heating (progressing from a pre-SMO 702 shape and location, to a shape and location adjusted to minimize metal layer mirror heating 704, to an adjusted shape and location configured to minimize metal layer sensitivity to mirror heating 706, and finally to a compromised illumination pupil 708). Top row 720 illustrates typical mirror heating aware SMO (e.g., SMO that accounts for mirror heating effects on a current metal layer of a pattern).

Middle row 730 and bottom row 740 illustrate embodiments of method 600 shown in Figure 6 and described herein. Middle row 730 illustrates a metal layer illumination pupil 700 (e.g., a source configuration of a lithographic apparatus for first features in a first layer of a pattern) optimized for (1) metal layer mirror heating and (2) for via layer sensitivity to metal layer mirror heating (e.g., systematic effects on the lithographic apparatus components that cause feature dependent imaging performance changes for second features in a second layer of the pattern). As shown in middle row 730, metal layer illumination pupil 700 is configured with feature shapes, sizes, and locations that generally accommodate or avoid via layer pupil 710 feature shapes, sizes, and locations (e.g., so as not to cause unnecessary heating). Thus, heating from patterning the metal layer is accounted for when determining the source configuration of the lithographic apparatus for vias in the via layer. The source configuration (e.g., an illumination pupil shape, size, location, etc.) is determined for the metal layer such that feature dependent imaging performance changes to vias in the via layer caused by the systematic effects on the lithographic apparatus components (e.g., mirror and/or lens heating) are reduced or eliminated.

In bottom row 740, metal layer illumination pupil 700 is optimized for metal layer mirror heating, and via layer illumination pupil 710 is optimized for via sensitivity to metal layer mirror heating. In this way, the source configuration is determined for the via layer such that the source configuration is less sensitive to the systematic effects on the lithographic apparatus components that cause feature dependent imaging performance changes to features in the metal layer compared to a sensitivity if the source configuration was determined based on features of the metal layer or the via layer alone.

Figure 8 illustrates an existing systematic effect (e.g., mirror heating) based SMO 800 compared to new systematic effect (e.g., mirror heating) based SMO methods 802 and 804 (e.g., both comprising different example embodiments of method 600) described herein. In SMO 800, a metal layer illumination pupil 810 causes 811 metal layer mirror heating 812. (Note that a metal illumination pupil and a metal layer are used as examples only.) A cost function based on EPE, NILS, and/or other key performance indicators is minimized 814 such that metal layer illumination pupil 810 is optimized for the effects 816 of metal layer mirror heating and for metal layer sensitivity 818 to the metal layer mirror heating.

In SMO 802, the cost function is changed (e.g., costs for another (e.g., via) layer are added). Metal layer illumination pupil 810 again causes 811 metal layer mirror heating 812. The cost function is again based on EPE, NILS, and/or other key performance indicators, and is minimized 814 such that metal layer illumination pupil 810 is optimized for the effects 816 of metal layer mirror heating and for metal layer sensitivity 818 to metal layer mirror heating. However, in SMO 802, the cost function is also minimized 820 such that metal layer illumination pupil 810 is co-optimized for the effects 816 of metal layer mirror heating on a via layer, and/or for via layer sensitivity 818 to metal layer mirror heating associated with the metal layer (e.g., using EPE, NILS, etc., for the via layer). SMO 800 and SMO 802 both (1) create less heating (e.g., less localized), and (2) are configured such that any created heating is less problematic (e.g., has less overlap with diffraction orders - as shown in Figure 7).

In SMO 804, metal layer illumination pupil 810 and (e.g., which causes 811) metal layer mirror heating 812 are considered known or fixed. A cost function based on via EPE, NILS, and/or other key performance indicators is minimized 820 such that a via layer illumination pupil 850 is optimized for the effects 852 of metal layer mirror heating and/or for via layer sensitivity 854 to the metal layer mirror heating. The effect of metal layer mirror heating is equivalent to the sensitivity of via here (because the metal is fixed, not affected here). Phrased another way, a mirror heating based SMO (e.g., SMO 804) input is changed (e.g., the optimization is for via layer illumination pupil 850 instead of metal layer illumination pupil 810). SMO 804 is configured such that given heating is less problematic (e.g., there is less overlap with diffraction orders).

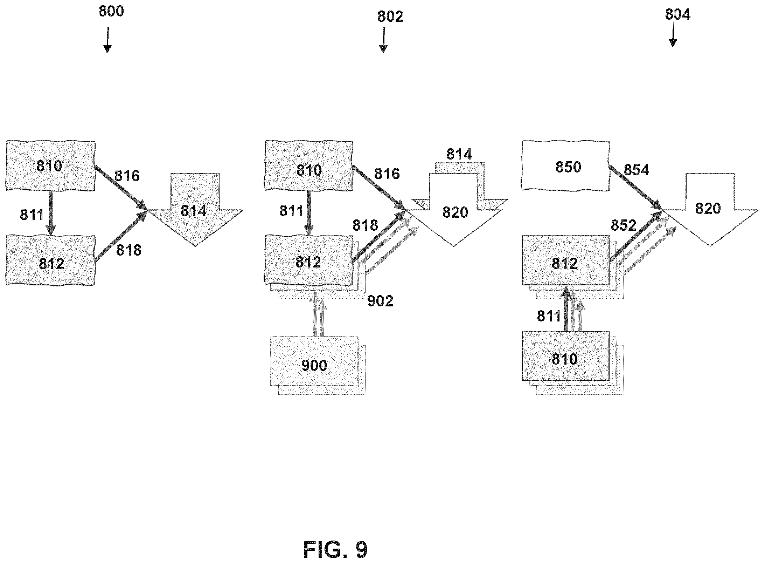

Figure 9 illustrates how the operations described above are not limited to input from just one layer. The SMO described herein may be based on systematic effects on the lithographic apparatus components (e.g., mirror heating as one example used in Figure 9, scanner cold lens aberration drift, etc.) caused by illumination pupils 900 (with a metal layer pupil as one example of a source configuration used in Figure 9), via layer illumination pupils, any amount of heating associated with source configurations, and/or changing lens setup residuals, for any number of further layers 902. In SMO 802 and SMO 804, for example, there may be additional mirror heating inputs. In some embodiments, for example, mirror heating Zernikes are simulated based on a pupil and a diffracted pupil (which uses a weighted sum of diffraction orders over reticle features). Both may change after every iteration of SMO. For a first use case (center in Figure 9) the cost function is a combination of metal and via related variables. For a second use case (Figure 9 right), a mirror heating model is run once, because the metal illumination pupil design is already fixed.

Returning to Figure 6, the lithographic apparatus comprises an illumination source, projection optics, and/or other components configured to image the pattern onto the substrate (as described above related to Figure 1). In some embodiments, performing the source mask optimization (e.g., performing method 600) comprises modeling a lithographic process for imaging the pattern onto the substrate. A model for modeling the process for imaging the pattern onto the substrate uses a determined source configuration (e.g., from operation 602) and/or other information.

At operation 604, one or more adjustments are determined for one or more of the source configuration, the pattern, the projection optics, the illumination source, and/or other components of a lithography apparatus. The adjustment(s) are determined based on modeled systematic effects on the lithographic apparatus components that cause the feature dependent imaging performance changes and/or other information. Adjustments are performed until a termination condition is satisfied, for example. The termination condition may comprise a determination that (a model simulation of) features patterned onto the substrate will substantially match a target design and/or other termination conditions. Phrased another way, the systematic effect aware SMO of method 600 is performed (by optimizing a cost function as described above) until a model simulation determination that features patterned onto the substrate will substantially match the target design.

In some embodiments, operation 604 comprises determining an adjustment for a semiconductor device manufacturing process. In some embodiments, operation 604 includes determining one or more semiconductor device manufacturing process parameters. The one or more semiconductor device manufacturing process parameters may be determined based on expected printed pattern characteristics, for example, and/or other information. In some embodiments, process parameters can be interpreted broadly to include a stage position, a mask design, a metrology target design, a semiconductor device design, an intensity of the radiation (used for exposing resist, etc.), an incident angle of the radiation (used for exposing resist, etc.), a wavelength of the radiation (used for exposing resist, etc.), a pupil size and/or shape, a resist material, and/or other parameters.

In some embodiments, operation 604 includes determining a process adjustment based on the one or more determined semiconductor device manufacturing process parameters, adjusting a semiconductor device manufacturing apparatus based on the determined adjustment, and/or other operations. For example, if a determined metrology measurement is not within process tolerances, the out of tolerance measurement may be caused by one or more manufacturing processes whose process parameters have drifted and/or otherwise changed so that the process is no longer producing acceptable devices (e.g., measurements may breach a threshold for acceptability). One or more new or adjusted process parameters may be determined based on the measurement determination. The new or adjusted process parameters may be configured to cause a manufacturing process to again produce acceptable devices.

For example, a new or adjusted process parameter may cause a previously unacceptable measurement value to be adjusted back into an acceptable range. The new or adjusted process parameters may be compared to existing parameters for a given process. If there is a difference, that difference may be used to determine an adjustment for an apparatus that is used to produce the devices (e.g., parameter "x" should be increased / decreased / changed so that it matches the new or adjusted version of parameter "x" determined as part of method 600), for example. In some embodiments, method 600 may include electronically adjusting an apparatus (e.g., based on the determined process parameters). Electronically adjusting an apparatus may include sending an electronic signal, and/or other communications to the apparatus, for example, which causes a change in the apparatus. The electronic adjustment may include changing a setting on the apparatus, for example, and/or other adjustments.

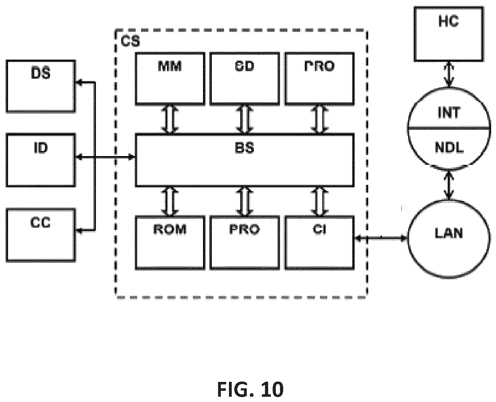

Figure 10 is a diagram of an example computer system CS (which may be similar to or the same as CS shown in Figure 3) that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more operations described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" or a "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have (machine-readable) instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more machine-readable instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, or stored in storage device SD, or other non-volatile storage for later execution. In this manner, computer system CS may obtain application code in the form of a carrier wave.

The concepts disclosed herein may be used with any imaging, etching, polishing, inspection, etc. system for sub wavelength features, and may be useful with emerging imaging technologies capable of producing increasingly shorter wavelengths. Emerging technologies include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-50nm by using a synchrotron or by hitting a material (either solid or a plasma) with high energy electrons in order to produce photons within this range.

Embodiments of the present disclosure can be further described by the following clauses:

1. A method for source mask optimization for a lithographic apparatus, the lithographic apparatus comprising components configured to image a pattern onto a substrate, the method comprising:
determining a source configuration of the lithographic apparatus for processing first features in a first layer based on a systematic effect on the lithographic apparatus components associated with processing second features in a second layer, wherein the first layer and the second layer are different layers.

2. The method of clause 1, wherein the systematic effect on the lithographic apparatus components is determined by simulation.

3. The method of clauses 1- 2, further comprising performing source mask optimization based on the systematic effect.

4. The method of any of clauses 1-3, wherein the systematic effect on the lithographic apparatus components comprise component heating, component cooling, component drift, component variation for different substrate lots, illumination offsets, mask to mask changes, overlay effects, aberration effects, fading, re-calibration or re-set up, and/or dose or pupil residuals.

5. The method of any of clauses 1-4, wherein the lithographic apparatus components comprise a mirror and/or a lens, and the systematic effect on the lithographic apparatus comprises mirror and/or lens heating.

6. The method of any of clauses 1-5, wherein the systematic effect on the lithographic apparatus components varies over time during exposure.

7. The method of any of clauses 1-6, wherein the systematic effect on the lithographic apparatus components causes feature dependent imaging performance changes for second features in the second layer.

8. The method of clause 7, wherein the feature dependent imaging performance changes comprise changes that vary based on a shape, location, dimensions, material, layer, and/or function of a feature in a layer.

9. The method of any of clauses 1-8, wherein the systematic effect on the lithographic apparatus components is caused by a first patterning operation with respect to the first layer, wherein the first patterning operation is performed prior to a second patterning operation with respect to the second layer.

10. The method of clause 9, wherein the systematic effect is simulated or measured based on the first patterning operation.

11. The method of clause 9, wherein determining the source configuration for processing the first layer comprises a source optimization process, wherein the source optimization process comprises simulation of a lithographic process associated with the first layer, and wherein the source optimization process comprises optimizing the source configuration based on a feature dependent imaging performance of second features in the second layer.

12. The method of clause 11, wherein optimizing the source configuration is performed by using a cost function indicating imaging performance of the second features in the second layer.

13. The method of clause 11, wherein the optimizing the source configuration is further based on a feature dependent imaging performance of first features in the first layer.

14. The method of any of clauses 1-8, wherein the systematic effect on the lithographic apparatus components is caused by a second patterning operation with respect to the second layer, wherein the second patterning operation is performed prior to a first patterning operation with respect to the first layer.

15. The method of clause 14, wherein systematic effect is simulated or measured based on the second patterning operation with respect to the second layer.

16. The method of clause 15, wherein determining the source configuration for processing the first layer comprises a source optimization process, wherein the source optimization process comprises simulation of a lithographic process associated with the first layer, and wherein the source optimization process comprises optimizing the source configuration based on imaging sensitivity of first features of the first layer to the systematic effect that is associated with the second patterning operation.

17. The method of clause 16, wherein determining the source configuration for processing the first layer is based on imaging sensitivity of first features of the first layer to the systematic effect associated with the second patterning operation.

18. The method of clause 14, wherein the imaging sensitivity corresponds to aberration sensitivity induced by the systematic effect.

19. The method of clause 14, wherein the optimizing the source configuration comprises using a cost function indicating aberration sensitivity of the first features of the first layer,wherein the sensitivity corresponds to aberration sensitivity of edge placement error (EPE), critical dimension (CD), and pattern placement error (PPE) sensitivities.

20. The method of clause 14, wherein determining the source configuration comprises an optimization process that uses a cost function including indication of the second layer's sensitivity to mirror heating induced aberration.

21. The method of clause 20, wherein the source is optimized to reduce aberration sensitivity induced by mirror heating.

22. The method of any of clauses 1-21, wherein determining a source configuration comprises determining an illumination pupil.

23. The method of any of clauses 1-22, wherein the first layer is a metal layer and the second layer is a via layer, the first layer is a via layer and the second layer is a metal layer, or the first and second layers are both metal or both via layers; and wherein the layers are associated with the same wafer, or different wafers in different production lots.

24. The method of any of clauses 1-23, wherein the first layer and the second layer are different layer types.

25. The method of any of clauses 1-24, wherein the lithographic apparatus components comprise an illumination source and projection optics configured to image the pattern onto the substrate; wherein the method further comprises determining one or more adjustments for one or more of the source configuration, the pattern, the projection optics, or the illumination source based on the systematic effects on the lithographic apparatus components, wherein the adjustment is performed on the lithographic apparatus in production.

26. The method of any of clauses 1-25, wherein performing the source mask optimization comprises modeling a lithographic process for imaging a pattern onto the substrate.

27. A non-transitory computer readable medium having instructions thereon, the instructions when executed by a computer implementing the method of any of clauses 1-26.

28. A system comprising one or more processors configured by machine readable instructions to perform the method of any of clauses 1-26.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

## Claims

1.  A method for source mask optimization for a lithographic apparatus, the lithographic apparatus comprising components configured to image a pattern onto a substrate, the method comprising:
    determining a source configuration of the lithographic apparatus for processing first features in a first layer based on a systematic effect on the lithographic apparatus components associated with processing second features in a second layer, wherein the first layer and the second layer are different layers.

2.  The method of claim 1, further comprising determining the systematic effect on the lithographic apparatus components by simulation or measurement, and further comprising performing source mask optimization based on the systematic effect, wherein determining a source configuration comprises determining an illumination pupil, wherein the systematic effect on the lithographic apparatus components comprise component heating, component cooling, component drift, component variation for different substrate lots, illumination offsets, mask to mask changes, overlay effects, aberration effects, fading, re-calibration or re-set up, and/or dose or pupil residuals.

3.  The method of claim 1, wherein the lithographic apparatus components comprise a mirror and/or a lens, and the systematic effect on the lithographic apparatus comprises mirror and/or lens heating.

4.  The method of claim 1, wherein the systematic effect on the lithographic apparatus components is caused by a first patterning operation with respect to the first layer, wherein the first patterning operation is performed prior to a second patterning operation with respect to the second layer.

5.  The method of claim 4, wherein determining the source configuration for processing the first layer comprises a source optimization process, wherein the source optimization process comprises simulation of a lithographic process associated with the first layer, and wherein the source optimization process comprises iteratively optimizing the source configuration based on a feature dependent imaging performance of second features in the second layer.

6.  The method of claim 5, wherein optimizing the source configuration is performed by using a cost function indicating imaging performance of the second features in the second layer.

7.  The method of claim 6, wherein the optimizing the source configuration is further based on a feature dependent imaging performance of first features in the first layer.

8.  The method of claim 1, wherein the systematic effect on the lithographic apparatus components is caused by a second patterning operation with respect to the second layer, wherein the second patterning operation is performed prior to a first patterning operation with respect to the first layer, and wherein systematic effect is simulated or measured based on the second patterning operation with respect to the second layer.

9.  The method of claim 8, wherein determining the source configuration for processing the first layer comprises a source optimization process, wherein the source optimization process comprises simulation of a lithographic process associated with the first layer, and wherein the source optimization process comprises optimizing the source configuration based on imaging sensitivity of first features of the first layer to the systematic effect that is associated with the second patterning operation.

10. The method of claim 9, wherein determining the source configuration for processing the first layer comprises iteratively optimizing the source configuration based on imaging sensitivity of first features of the first layer to the systematic effect associated with the second patterning operation.

11. The method of claim 10, wherein the imaging sensitivity corresponds to aberration sensitivity induced by the systematic effect.

12. The method of claim 11, wherein the optimizing the source configuration comprises using a cost function indicating aberration sensitivity of the first features of the first layer, wherein the sensitivity corresponds to aberration sensitivity of edge placement error (EPE), critical dimension (CD), and pattern placement error (PPE) sensitivities.

13. The method of claim 1, wherein the first layer is a metal layer and the second layer is a via layer, the first layer is a via layer and the second layer is a metal layer, or the first and second layers are both metal or both via layers; and wherein the layers are associated with the same wafer, or different wafers in different production lots.

14. The method of claim 1, wherein the first layer and the second layer are different layer types.

15. The method of Claim 14, wherein the lithographic apparatus components comprise an illumination source and projection optics configured to image the pattern onto the substrate; wherein the method further comprises determining one or more adjustments for one or more of the source configuration, the pattern, the projection optics, or the illumination source based on the systematic effects on the lithographic apparatus components, wherein the adjustment is performed on the lithographic apparatus in production.

FIG. 1

FIG. 2

FIG. 3

**FIG. 4**

FIG. 5

600

602

604

FIG. 6

**FIG. 7**

FIG. 8

FIG. 9

FIG. 10

Europäisches
Patentamt

European
Patent Office

Office européen
des brevets

# EUROPEAN SEARCH REPORT

Application Number

EP 22 21 6705

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/212543 A1 (CROUSE MICHAEL MATTHEW M [US] ET AL) 15 August 2013 (2013-08-15) * paragraphs [0058] - [0065]; figure 4A * | 1-15 | INV. G03F7/20 |
| A | US 2019/137889 A1 (TEL WIM TJIBBO [US] ET AL) 9 May 2019 (2019-05-09) * paragraphs [0002], [0053] - [0063]; figures 2, 3A, 3B * | 1-15 | |
| A | CHEN AO ET AL: "Layer aware source mask target optimization", PROCEEDINGS OF SPIE; [PROCEEDINGS OF SPIE ISSN 0277-786X VOLUME 10524], SPIE, US, vol. 9780, 15 March 2016 (2016-03-15), pages 97801A-97801A, XP060070213, DOI: 10.1117/12.2219864 ISBN: 978-1-5106-1533-5 * the whole document * | 1-15 | |
| A | US 2014/047397 A1 (YE JUN [US] ET AL) 13 February 2014 (2014-02-13) * paragraphs [0070] - [0072]; figure 5 * | 1-15 | TECHNICAL FIELDS SEARCHED (IPC) G03F |
| A | BEKAERT J ET AL: "Characterization and control of dynamic lens heating effects under high volume manufacturing conditions", OPTICAL MICROLITHOGRAPHY XXIV, SPIE, 1000 20TH ST. BELLINGHAM WA 98225-6705 USA, vol. 7973, no. 1, 17 March 2011 (2011-03-17), pages 1-11, XP060009213, DOI: 10.1117/12.881609 [retrieved on 2011-03-22] * the whole document * | 1-15 | |

The present search report has been drawn up for all claims

| Place of search | Date of completion of the search | Examiner |
|---|---|---|
| Munich | 30 May 2023 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 21 6705

This annex lists the patent family members relating to the patent documents cited in the above-mentioned European search report.
The members are as contained in the European Patent Office EDP file on
The European Patent Office is in no way liable for these particulars which are merely given for the purpose of information.

30-05-2023

| Patent document cited in search report | | Publication date | Patent family member(s) | | Publication date |
|---|---|---|---|---|---|
| US 2013212543 | A1 | 15-08-2013 | CN 103246175 | A | 14-08-2013 |
| | | | JP 5801831 | B2 | 28-10-2015 |
| | | | JP 2013165271 | A | 22-08-2013 |
| | | | KR 20130092485 | A | 20-08-2013 |
| | | | TW 201341970 | A | 16-10-2013 |
| | | | US 2013212543 | A1 | 15-08-2013 |
| US 2019137889 | A1 | 09-05-2019 | TW 201800871 | A | 01-01-2018 |
| | | | US 2019137889 | A1 | 09-05-2019 |
| | | | WO 2017162471 | A1 | 28-09-2017 |
| US 2014047397 | A1 | 13-02-2014 | JP 5225463 | B2 | 03-07-2013 |
| | | | JP 2011522441 | A | 28-07-2011 |
| | | | US 2009296055 | A1 | 03-12-2009 |
| | | | US 2014047397 | A1 | 13-02-2014 |
| | | | WO 2009148976 | A1 | 10-12-2009 |

EPO FORM P0459

For more details about this annex : see Official Journal of the European Patent Office, No. 12/82

## REFERENCES CITED IN THE DESCRIPTION

**Patent documents cited in the description**

- US 9588438 B